(19) Europäisches Patentamt

European Patent Office

Office européen des brevets

(11) Veröffentlichungsnummer: **0 360 011 B1**

(12) **EUROPÄISCHE PATENTSCHRIFT**

(45) Veröffentlichungstag der Patentschrift: **16.02.94**

(21) Anmeldenummer: **89115387.6**

(22) Anmeldetag: **21.08.89**

(51) Int. Cl.⁵: **H01S 3/103**, H01S 3/06, H01S 3/19, H01S 3/085

(54) **Abstimmbarer DFB-Laser.**

(30) Priorität: **22.09.88 DE 3832240**

(43) Veröffentlichungstag der Anmeldung:
**28.03.90 Patentblatt 90/13**

(45) Bekanntmachung des Hinweises auf die
Patenterteilung:
**16.02.94 Patentblatt 94/07**

(84) Benannte Vertragsstaaten:
**DE FR GB**

(56) Entgegenhaltungen:
**EP-A- 0 296 066**
**DE-A- 3 708 666**
**US-A- 4 607 370**

**ELECTRONICS LETTERS, Band 24, Nr. 15, 21. Juli 1988, Seiten 947-949, Stevenage, Herts, GB; C.Y. KUO et al.: "Characteristics of two-electrode DFB lasers"**

**PATENT ABSTRACTS OF JAPAN, Band 13, Nr. 97 (E-723)[3445], 7. März 1989;& JP-A-63 272 088**

**PATENT ABSTRACTS OF JAPAN, Band 10, Nr. 317 (E-449)[2373], 28. Oktober 1986;& JP-**

A-61 128 589

(73) Patentinhaber: **SIEMENS AKTIENGESELL-SCHAFT**
**Wittelsbacherplatz 2**
**D-80333 München(DE)**

(72) Erfinder: **Amann, Markus-Christian, Dr.-Ing.**
**Unterhachingerstrasse 89**
**D-8000 München 83(DE)**

**Beschreibung**

Für moderne optische Nachrichtensystem werden bevorzugt einwellige (einfrequente) Laserdioden benötigt, deren Wellenlänge kontinuierlich in einem gewissen Bereich (zum Beispiel 0.5 - 1 nm bei 1.55 $\mu$m Wellenlänge) abstimmbar ist.

Die Herstellung entsprechender einwelliger Laserdioden erfolgt heute fast ausschließlich mittels des Prinzips der verteilten Rückkopplung. Diese Laser werden deshalb als Distributed-Feed-Back (DFB) oder Distributed Bragg Reflector (DBR) Laser bezeichnet. Eine Abstimmung der Wellenlänge wurde dabei bisher durch Änderung der Brechzahl im Gebiet des Bragg-Gitters (bzw. der Braggwellenlänge) erzeugt. Zu diesem Zweck werden die Laser longitudinal in mehrere Sektionen aufgeteilt und mit getrennten Elektroden versehen. Ein entscheidender Nachteil dieser Konfigurationen (siehe zum Beispiel C. Y. Kuo, N. K. Dutta: "Characteristics of Two-Electrode DFB-Lasers", Electronics Letters 24, 947-949 (1988)) stellen Inhomogenitäten bzw. Sprünge in der Abstimmung dar (Longitudinaler Modenwechsel). Dieser Nachteil kann durch zusätzliches Anbringen einer dritten Sektion bzw. einer vierten Elektrode vermieden werden. Jedoch muß die Aufteilung der Ströme auf die drei Sektionen in engen Grenzen erfolgen, die mittels einer sehr aufwendigen Meßtechnik gefunden werden. Diese Art des Betriebs ist in der Praxis extrem kritisch und die Bauelementealterung kann dennoch zu Modenwechsel führen, da sich nach einigen tausend Betriebsstunden die Aufteilung der Ströme unvorhersehrbar ändern kann.

In der US 4 607 370 ist ein Halbleiterlaser beschrieben, bei dem übereinander zwei aktive Schichten, die durch eine inaktive Schicht getrennt sind, angeordnet sind. Es ist für die inaktive Zwischenschicht ein gemeinsamer Kontakt vorgesehen, während für die aktiven Bereiche in der oberen und der unteren aktiven Schicht weitere getrennte Kontakte für getrennte Strominjektion vorgesehen sind. Die Schichtstruktur besteht aus GaAs-Schichten, die jeweils durch AlGaAs-Schichten getrennt sind.

Aufgabe der vorliegenden Erfindung ist es, einen einfach herstellbaren und einfach kontaktierbaren Aufbau für einen abstimmbaren DFB-Laser anzugeben.

Diese Aufgabe wird mit dem abstimmbaren DFB-Laser mit den Merkmalen des Anspruches 1 gelöst. Weitere Ausgestaltungen ergeben sich aus den abhängigen Ansprüchen.

Die vorliegende Erfindung löst das Problem der kontinuierlichen Abstimmung dadurch, daß keine longitudinale sondern eine transversale Segmentierung des Lasers erfolgt. Dieser Erfindung liegt die Erkenntnis zugrunde, daß bei transversaler Abstimmung prinzipiell keine Inhomogenität durch Wechsel der longitudinalen Moden auftritt. Bei einer derartigen Laserstruktur tritt das technische Problem auf, den strahlungserzeugenden Bereich von dem für die Abstimmung vorgesehenen Bereich zu trennen, eine getrennte Ansteuerung zu ermöglichen, doch gleichzeitig eine wirkungsvolle Abstimmbarkeit zu erzielen. Die vorliegende Erfindung löst dieses Problem durch eine Zentralschicht, die sich zwischen dem Abstimmbereich und dem aktiven Bereich befindet und über die sich beide Bereiche durch die angelegten Spannungen ansteuern lassen. Der eigentliche DFB-Laser befindet sich auf einem Substrat, das für der Zentralschicht entgegengesetzte Leitungstyp dotiert ist. Auf der entgegengesetzten Seite der Zentralschicht ist in ausreichender Nähe zur aktiven Schicht eine abstimmbare Schicht angeordnet. Durch die transversale Anordnung von aktiver Schicht und Abstimmschicht ermöglicht der erfindungsgemäße Aufbau eine problemlose Abstimmung des Lasers.

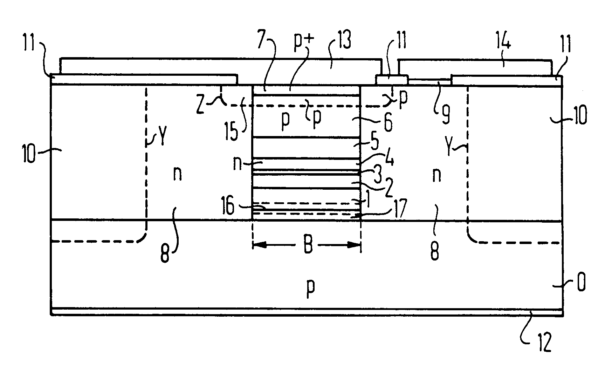

Es folgt die Beschreibung eines Ausführungsbeispiels anhand der Figur. Auf einem Substrat 0 befindet sich auf der einen Hauptseite ein Substratkontakt 12 aus Metall und auf der gegenüberliegenden Hauptseite eine streifenförmig geätzte Schichtfolge aus Halbleitermaterial. Diese Schichtfolge besteht nacheinander aus einer Pufferschicht 17 und einer Gitterschicht 1, deren gemeinsame Grenzfläche das Gitter 16 bildet, der aktiven Schicht 2, gegebenenfalls einer Anti-melt-back-Schicht 3, einer Zentralschicht 4, einer Abstimmschicht 5, einer Deckschicht 6 und gegebenenfalls einer Hauptkontaktschicht 7. Seitlich dieses streifenförmigen Schichtaufbaues befinden sich Seitenbereiche 8, die ihrerseits durch Passivierungsbereiche 10 nach außen begrenzt sind. Die Anti-melt-back-Schicht 3 und die Hauptkontaktschicht 7 können unter Umständen entfallen. Die Gitterschicht 1 kann auch entfallen; das Gitter 16 ist dann in die Abstimmschicht 5 einzubauen, wobei dann diese Abstimmschicht 5 aus zwei Schichten unterschiedlichen Brechungsindexes aufgebaut ist. Die Anordnung der Abstimmschicht 5 und der aktiven Schicht 2 kann dann auch vertauscht sein, d. h. die Abstimmschicht 5 kann sich unmittelbar auf dem Substrat 0 befinden und die aktive Schicht 2 die Stelle der Abstimmschicht 5 einnehmen. Die Deckschicht 6 bzw. die Hauptkontaktschicht 7 ist mit einem Mittenkontakt 13 aus Metall versehen; mindestens ein Seitenbereich 8 ist mit einem Seitenkontakt 14 versehen. Zur besseren Kontaktierung kann dieser Seitenkontakt 14 auf einer auf dem Seitenbereich 8 aufgebrachten hoch dotierten seitlichen Kontaktschicht 9 aufgebracht sein. Die Isolation der Kontakte 13, 14 von dem Halbleitermaterial außerhalb der für die Kontaktierung vorgesehenen Bereiche der Oberfläche erfolgt durch eine Passivierungsschicht 11. Substrat 0, Pufferschicht 17, Zentralschicht 4, Deckschicht 6 und die Seitenbereiche 8 sind InP, die übrigen Anteile des Halbleitermaterials sind vorzugsweise quaternäres Material (InGaAsP). Für p-Leitung dotiert sind das Substrat 0, die Gitterschicht 1, die Deckschicht 6, die Pufferschicht 17, die Hauptkontaktschicht 7 und gegebenenfalls die Abstimmschicht 5. Für n-Leitung dotiert sind die Zentralschicht 4, gegebenenfalls die Abstimmschicht 5, die Seitenbereiche 8 und, falls vorhanden, die seitliche Kontaktschicht 9. Die Hauptkontaktschicht 7 und die seitliche Kontaktschicht 9 sind jeweils hoch dotiert. Die Dotierung aller Schichten und des Substrates 0 kann auch für jeweils entgegengesetzten Leitfähigkeitstyp vorgenommen sein (komplementäre Struktur), die vorstehend beschriebene Ausführung ist aber vorteilhaft.

Genauere Angaben über Aufbau und Abmessung der einzelnen Schichten können aus der nachfolgenden Tabelle entnommen werden. Die Nummer gibt jeweils das Bezugszeichen der betreffenden Schicht an. Weiter sind chemische Zusammensetzung ch, Wellenlänge entsprechend der Bandkante $l_g$, Vorzeichen der Dotierung c, Höhe der Dotierung d, Dicke th, und für ein typisches Ausführungsbeispiel die Wellenlänge $l_g$, die Höhe der Dotierung d und die Schichtdicke th angegeben. Die Wellenlänge von 1.67 $\mu$m ergibt sich für InGaAs gitterangepaßt auf InP. Diese Strukturvariante basiert auf dem Prinzip des PBRS-Lasers (W. Thulke, A. Zach, H.-D. Wolf: "Planar Buried-Ridge-Structure (PBRS) Lasers with Emission Wavelengths of 1.3 $\mu$m and 1.55 $\mu$m for Optical Communication Systems", Siemens Forschungs- und Entwicklungsberichte 17, 1-5 (1988)).

Die transversale Trennung von Abstimmbereich (Abstimmschicht 5) und Verstärkungsbereich (aktive Schicht 2) erfolgt hierbei mittels der dünnen n-InP-Schicht (Zentralschicht 4) zwischen der p-dotierten Abstimmschicht 5 und der aktiven Schicht 2. Diese Zentralschicht 4 trennt dabei die Löcherinjektion in die aktive Schicht 2 von der Löcherinjektion in die Abstimmschicht 5, und beide Schichten können unabhängig voneinander betrieben, das heißt mit Spannung versorgt werden. Der Elektronenfluß verläuft dabei gemeinsam über die Seitenbereiche 8 aus n-InP und die zugehörige Elektrode an dem Seitenkontakt 14. Die Löcherinjektion in die Abstimmschicht 5 erfolgt von der an dem Mittenkontakt 13 angebrachten Elektrode über die Hauptkontaktschicht und die Deckschicht 6 aus jeweils p-dotiertem Material. Die Löcherinjektion in die aktive Schicht 2 zur Strahlungserzeugung erfolgt über den Substratkontakt 12 durch das Substrat, die Pufferschicht 17 und die Gitterschicht 1.

Je nach Höhe der Löcherinjektion in die Abstimmschicht 5 ändert sich die Brechzahl dieser Abstimmschicht 5 und damit die effektive Brechzahl des gesamten Laserwellenleiters sowie die effektive Bragg-Wellenlänge des eingebauten Gitters 16. Der Elektronenfluß in den Seitenbereichen 8 ist durch deren Abmessung seitlich begrenzt. Nebenströme werden teilweise durch die Schicht nach außen an die Seitenbereiche 8 anschließenden Passivierungsbereiche 10 vermieden. Diese Passivierungsbereiche 10 sind zum Beispiel hergestellt durch Protonenimplantation oder p-Diffusion in das zur Ausbildung der Seitenbereiche 8 seitlich aufgewachsene Material.

Sowohl die aktive Schicht 2 als auch die Abstimmschicht 5 können eine Struktur aufweisen, wie sie für den Quantumwell-Effekt erforderlich ist. Da für die Funktionsweise dieser Schichten eine gewisse Dicke erforderlich ist, wird bei der Herstellung solcher spezieller Strukturen ein Aufbau einer Multi-Quantum-well-Struktur vorteilhaft sein. Dabei handelt es sich um eine Aufeinanderfolge von relativ sehr dünnen Halbleiterschichten aus abwechselnd binärem und quaternärem Material. Eine andere Möglichkeit, den quantum-well-Effekt auszunutzen und gleichzeitig für eine hinreichend große Schichtdicke zu sorgen, bietet die separate confinement structure. Bei dieser Struktur wird die eigentliche Schicht, d.h. in diesem Fall die aktive Schicht 2 bzw. die Abstimmschicht 5, für den quantum-well-Effekt entsprechend bemessen; oberhalb und unterhalb dieser sehr dünnen Schicht sind angrenzend Schichten aus Halbleitermaterial mit sich kontinuierlich nach außen veränderndem Energiebandabstand aufgewachsen. Wenn insbesondere die Abstimmschicht 5 eine quantum-well-Struktur aufweist, können durch für den quantum-confined-Starkeffekt gepolten Anschluß in der Abstimmschicht 5 verbesserte Abstimmeigenschaften erzielt werden.

Eine äquivalente abstimmbare Laserdiode läßt sich auch auf n-Substrat, mit einer geänderten Schichtenfolge oder in einem anderen System von Halbleitermaterialien (wie z. B. AlGaAs-GaAs) herstellen. Ein entscheidendes Merkmal der Erfindung stellt dabei die transversale Parallelschaltung zweier Schichten unterschiedlichen Bandabstandes dar, in die eine getrennte Strominjektion zum Zwecke der Brechzahländerung möglich ist.

| Nr. | ch | $l_g/\mu m$ | c | $d/10^{18} cm^{-3}$ | $th/\mu m$ | $l_g/\mu m$ | $d/10^{18} cm^{-3}$ | $th/\mu m$ |
|---|---|---|---|---|---|---|---|---|
| 0 | InP | 0.92 | p | 5 | 50...200 | 0.92 | 5 | 80 |
| 1 | q | 1.0...1.4 | p | 0...1 | 0.1...0.3 | 1.15 | - | 0.15 |
| 2 | q | 1.3...1.67 | - | - | 0.05...0.3 | 1.55 | - | 0.12 |
| 3 | q | 1.2...1.4 | - | - | 0...0.1 | 1.3 | - | 0.05 |
| 4 | InP | 0.92 | n | 0.1...10 | 0.05...0.5 | 0.92 | 1 | 0.1 |
| 5 | q | 1.1...1.5 | p,n | 0...1 | 0.05...0.5 | 1.3 | - | 0.3 |
| 6 | InP | 0.92 | p | 0.1...1 | 1...3 | 0.92 | 0.4 | 1.5 |
| 7 | q | 1.1...1.67 | p | 10...100 | 0.05...0.5 | 1.67 | 60 | 0.2 |
| 8 | InP | 0.92 | n | 0.3...10 | 1.5...5 | 0.92 | 1 | 2.5 |
| 9 | q | 1.1...1.67 | n | 1...50 | 0.05...0.5 | 1.67 | 4 | 0.2 |
| 17 | InP | 0.92 | P | 0.1-2 | 0...10 | 0.92 | 0.5 | 2 |

q = InGaAsP
Breite B ist 0,5 – 10 µm, typisch 2 µm.

**Patentansprüche**

1. Abstimmbarer DFB-Laser aus Halbleitermaterial auf einem für elektrische Leitung eines ersten Leitungstyps dotierten Substrat (O),

4

mit streifenförmigen übereinander aufgewachsenen Schichten,
zu denen eine aktive Schicht (2), eine Abstimmschicht (5) und eine Zentralschicht (4) gehören, wobei die aktive Schicht (2) und die Abstimmschicht (5) aus Materialien mit unterschiedlichen Energiebandabständen sind und transversal zu den Schichtebenen parallel zueinander angeordnet sind und wobei die Zentralschicht (4) für den zum Leitungstyp des Substrates (O) entgegengesetzten Leitungstyp dotiert und zwischen der aktiven Schicht (2) und der Abstimmschicht (5) angeordnet ist , und getrennte Strominjektion in die aktive Schicht (2) und in die Abstimmschicht (5) ermöglicht,
mit einem außerhalb der aktiven Schicht (2) als Grenzfläche zweier Schichten mit unterschiedlichen Brechungsindizes ausgebildeten DFB-Gitter (16) und
mit seitlich dieses streifenförmigen Schichtaufbaus befindlichen Seitenbereichen (8), die durch elektrisch isolierende Passivierungsbereiche (10) nach außen begrenzt sind.

2. Abstimmbarer DFB-Laser nach Anspruch 1,
   **dadurch gekennzeichnet,**
   daß die aktive Schicht (2) auf der dem Substrat (O) zugewandten Seite der Zentralschicht (4) ist und
   daß das Gitter (16) durch eine Grenzfläche der Abstimmschicht (5) gebildet ist.

3. Abstimmbarer DFB-Laser nach einem der Ansprüche 1 bis 2,
   dadurch **gekennzeichnet,**
   daß die Abstimmschicht (5) auf der dem Substrat (O) zugewandten Seite der Zentralschicht (4) ist und
   daß das Gitter (16) durch eine Grenzfläche der Abstimmschicht (5) gebildet ist.

4. Abstimmbarer DFB-Laser nach einem der Ansprüche 1 bis 3,
   **dadurch gekennzeichnet,**
   daß sich die aktive Schicht (2) auf der dem Substrat (O) zugewandten Seite der Zentralschicht (4) befindet,
   daß zwischen der aktiven Schicht (2) und dem Substrat (O) eine Gitterschicht (1) vorgesehen ist und
   daß das Gitter (16) durch die dem Substrat (O) zugewandte Grenzfläche dieser Gitterschicht (1) gebildet ist.

5. Abstimmbarer DFB-Laser nach einem der Ansprüche 1 bis 4,
   dadurch **gekennzeichnet,**
   daß mindestens eine Schicht aus der Gruppe von aktiver Schicht (2) und Abstimmschicht (5) jeweils eine Struktur aus der Gruppe von quantum-well structure, multi-quantum-well structure und separate confinement heterostructure (SCH) aufweist.

6. Abstimmbarer DFB-Laser nach einem der Ansprüche 1 bis 5,
   dadurch **gekennzeichnet,**
   daß eine für den Leitungstyp des Substrates (O) dotierte Deckschicht (6) auf der dem Substrat (O) abgewandten Seite des streifenförmigen Schichtaufbaues aufgebracht ist,
   daß auf der Deckschicht (6) eine hoch für denselben Leitungstyp dotierte Hauptkontaktschicht (7) aufgebracht ist,
   daß die Schichtfolge (1,2,4,5,6,7) streifenförmig geätzt ist,
   daß die Schichtfolge (1,2,4,5,6,7) seitlich durch auf das Substrat (O) aufgewachsene Seitenbereiche (8) bis auf die Höhe der dem Substrat (O) abgewandten Seite der Hauptkontaktschicht (7) eingefaßt ist,
   daß diese Seitenbereiche (8) für denselben Leitungstyp wie die Zentralschicht (4) dotiert sind,
   daß diese Seitenbereiche (8) im Hinblick auf seitliche Begrenzung des Strompfades bemessen sind,
   daß an diese Seitenbereiche (8) angrenzend und an der Oberfläche bündig abschließend elektrisch isolierende Passivierungsbereiche (10) ausgebildet sind,
   daß die der überwachsenen Hauptseite abgewandte Hauptseite des Substrates (O) mit einem Substratkontakt (12) versehen ist,
   daß die Hauptkontaktschicht (7) mit einem Mittenkontakt (13) versehen ist und
   daß mindestens ein Seitenbereich (8) mit einem Seitenkontakt (14) versehen ist.

7. Abstimmbarer DFB-Laser nach Anspruch 6,
   dadurch **gekennzeichnet,**
   daß zu jedem Seitenkontakt (14) eine seitliche Kontaktschicht (9) auf die Oberfläche des betreffenden Seitenbereiches (8) aufgewachsen ist,

daß diese seitliche Kontaktschicht (9) hoch für denselben Leitungstyp wie der Seitenbereich (8) dotiert ist und

daß der Seitenkontakt (14) jeweils auf dieser seitlichen Kontaktschicht (9) aufgebracht ist.

**8.** Abstimmbarer DFB-Laser nach Anspruch 6 oder 7,
dadurch **gekennzeichnet,**
daß ein Diffusionsbereich (15), der an den mit dem Mittenkontakt (13) versehenen Teil der Oberfläche der Halbleiterschicht angrenzt, ausgebildet ist,
daß dieser Diffusionsbereich (15) einen dem Leitungstyp der Seitenbereiche (8) entgegengesetzten Leitungstyp aufweist und daß dieser Diffusionsbereich (15) den Mittenkontakt (13) von den Seitenbereichen (8) elektrisch isoliert.

**9.** Abstimmbarer DFB-Laser nach einem der Ansprüche 6 bis 8,
dadurch **gekennzeichnet,**
daß das Substrat (O) die Zentralschicht (4), die Deckschicht (6) und die Seitenbereiche (8) binäres Material sind und
daß übrige Schichten quaternäres Material sind.

**10.** Abstimmbarer DFB-Laser nach Anspruch 9,
dadurch **gekennzeichnet,**
daß das binäre Material InP ist und das quaternäre Material InGaAsP ist.

**11.** Abstimmbarer DFB-Laser nach Anspruch 9,
dadurch **gekennzeichnet,**
daß das binäre Material InP ist und das quaternäre Material AlGaInAs ist.

**12.** Abstimmbarer DFB-Laser nach einem der Ansprüche 1 bis 8,
dadurch **gekennzeichnet,**
daß das Substrat (O) GaAs ist und
daß die übrigen Schichten $Al_xGa_{1-x}As$ ($0 \leq x \leq 1$) sind.

**13.** Abstimmbarer DFB-Laser nach einem der Ansprüche 1 bis 8,
dadurch **gekennzeichnet,**
daß das Substrat (O) GaSb ist und
daß die übrigen Schichten aus dem System GaSb/GaInAlAsSb sind.

**Claims**

**1.** Tunable DFB laser of semiconductor material on a substrate (O) doped for electrical conduction of a first conductivity type, having strip-shaped layers which are grown one upon another and which comprise an active layer (2), a tuning layer (5) and a central layer (4), the active layer (2) and the tuning layer (5) comprising materials having differing energy band gaps and being disposed parallel to one another transversely to the layer planes, and the central layer (4) being doped for the conductivity type opposite to the conductivity type of the substrate (O) and being disposed between the active layer (2) and the tuning layer (5) and permitting separate current injection into the active layer (2) and into the tuning layer (5), having a DFB grating (16) formed outside the active layer (2) as boundary surface of two layers having differing refractive indices, and having lateral regions (8) which are situated laterally of this strip-shaped layer structure and which are outwardly bounded by electrically insulating passivation regions (10).

**2.** Tunable DFB laser according to Claim 1, characterised in that the active layer (2) is on that side of the central layer (4) which faces the substrate (O), and in that the grating (16) is formed by a boundary surface of the tuning layer (5).

**3.** Tunable DFB laser according to one of Claims 1 or 2, characterised in that the tuning layer (5) is on that side of the central layer (4) which faces the substrate (O), and in that the grating (16) is formed by a boundary surface of the tuning layer (5).

6

**4.** Tunable DFB laser according to one of Claims 1 to 3, characterised in that the active layer (2) is situated on that side of the central layer (4) which faces the substrate (O), in that a grating layer (1) is provided between the active layer (2) and the substrate (O), and in that the grating (16) is formed by that boundary surface of this grating layer (1) which faces the substrate (O).

**5.** Tunable DFB laser according to one of Claims 1 to 4, characterised in that at least one layer selected from the group comprising active layer (2) and tuning layer (5) exhibits in each instance a structure selected from the group comprising quantum-well structure, multi-quantum-well structure and separate confinement hetero-structure (SCH).

**6.** Tunable DFB laser according to one of Claims 1 to 5, characterised in that a cover layer (6) doped for the conductivity type of the substrate (O) is applied to that side of the strip-shaped layer structure which faces away from the substrate (O), in that a main contact layer (7) highly doped for the same conductivity type is applied to the cover layer (6), in that the sequence of layers (1, 2, 4, 5, 6, 7) is etched in a strip-shaped configuration, in that the sequence of layers (1, 2, 4, 5, 6, 7) is laterally framed by lateral regions (8) grown on the substrate (O) up to the height of that side of the main contact layer (7) which faces away from the substrate (O), in that these lateral regions (8) are doped for the same conductivity type as the central layer (4), in that these lateral regions (8) are dimensioned to provide lateral limitation of the current path, in that electrically insulating passivation regions (10) are formed adjacent to these lateral regions (8) and terminating so as to be flush with the surface, in that that main side of the substrate (O) which faces away from the overgrown main side is provided with a substrate contact (12), in that the main contact layer (7) is provided with a central contact (13), and in that at least one lateral region (8) is provided with a lateral contact (14).

**7.** Tunable DFB laser according to Claim 6, characterised in that for each lateral contact (14) a lateral contact layer (9) is grown on the surface of the pertinent lateral region (8), in that this lateral contact layer (9) is highly doped for the same conductivity type as the lateral region (8), and in that the lateral contact (14) is applied in each instance to this lateral contact layer (9).

**8.** Tunable DFB laser according to Claim 6 or 7, characterised in that a diffusion region (15), which adjoins that part of the surface of the semiconductor layer which is provided with the central contact (13), is formed, in that this diffusion region (15) exhibits a conductivity type opposite to the conductivity type of the lateral regions (8), and in that this diffusion region (15) electrically insulates the central contact (13) from the lateral regions (8).

**9.** Tunable DFB laser according to one of Claims 6 to 8, characterised in that the substrate (O), the central layer (4), the cover layer (6) and the lateral regions (8) are binary material, and in that the remaining layers are quaternary material.

**10.** Tunable DFB laser according to Claim 9, characterised in that the binary material is InP and the quaternary material is InGaAsP.

**11.** Tunable DFB laser according to Claim 9, characterised in that the binary material is InP and the quaternary material is AlGaInAs.

**12.** Tunable DFB laser according to one of Claims 1 to 8, characterised in that the substrate (O) is GaAs and in that the remaining layers are $Al_xGa_{1-x}As$ (O $\leq$ x $\leq$ 1).

**13.** Tunable DFB laser according to one of Claims 1 to 8, characterised in that the substrate (O) is GaSb, and in that the remaining layers comprise the system GaSb/GaInAlAsSb.

**Revendications**

**1.** Laser DFB accordable, en un matériau semiconducteur sur un substrat (0) dopé pour fournir une conduction électrique d'un premier type, et comportant
des couches en forme de bandes formées par croissance en superposition et comprenant une couche active (2), une couche de réglage d'accord (5) et une couche centrale (4), la couche active (2) et la couche de réglage d'accord (5) étant en un matériau possédant des intervalles de bandes d'énergie différents et étant disposées parallèlement entre elles et transversalement par rapport au plan des couches, tandis que la couche centrale (4) est dopée de manière à présenter le type de conductivité opposé au type de conductivité du substrat (0) et est disposée entre la couche active (2) et la couche de réglage d'accord (5) et permet une injection distincte de courant dans la couche active (2) et dans la couche de réglage d'accord (5),

un réseau DFB (16) formé à l'extérieur de la couche active (2) en tant qu'interface entre deux couches ayant des indices de réfraction différents, et

des parties latérales (8) qui sont disposées latéralement par rapport à cette structure à couches en forme de bandes et qui sont délimitées vers l'extérieur par des zones de passivation électriquement isolantes (10).

2. Laser DFB accordable suivant la revendication 1, caractérisé par le fait
que la couche active (2) est sur le coté de la couche centrale (4) tournée vers le substrat (0), et
que le réseau (16) est formé par une interface de la couche de réglage d'accord (5).

3. Laser DFB accordable suivant les revendications 1 et 2, caractérisé par le fait
que la couche de réglage d'accord (5) est sur la face de la couche centrale (4) tournée vers le substrat (0), et
que le réseau (16) est formé par une interface de la couche de réglage d'accord (5).

4. Laser DFB accordable suivant l'une des revendications 1 à 3, caractérisé par le fait
que la couche active (2) est sur le coté de la couche centrale (4) tournée vers le substrat (0),
qu'une couche de réseau (1) est prévue entre la couche active (2) et le substrat (0), et
que le réseau (16) est formé par l'interface, tournée vers le substrat (0), de cette couche de réseau (1).

5. Laser DFB accordable suivant l'une des revendications 1 à 4, caractérisé par le fait
qu'au moins une couche constituée par le groupe formé par la couche active (2) et la couche accordable (5) possède respectivement une structure formée du groupe comprenant une structure à puits quantique, une structure à puits quantiques multiples et une hétérostructure distincte de confinement (SCH).

6. Laser DFB accordable suivant l'une des revendications 1 à 5, caractérisé par le fait
qu'une couche de revêtement dopée pour obtenir le type de conduction du substrat (0) est disposée sur la face de la structure à couches en forme de bandes, tournée à l'opposé du substrat (2),
qu'une couche de contact principal (7) fortement dopée pour fournir le même type de conduction, est déposée sur la couche de revêtement (6),
que la suite de couches (1,2,4,5,6,7) est corrodée sous la forme de bandes,
que la suite de couches (1,2,4,5,6,7) est enserrée latéralement par des parties latérales (8), formées par croissance sur le substrat (0), jusqu'à la hauteur de la face, tournée à l'opposé du substrat (0), de la couche de contact principal (7),
que ces parties latérales (8) sont dopées de manière à présenter le même type de conduction que la couche centrale (4),
que ces parties latérales (8) sont dimensionnées en fonction de la délimitation latérale de la voie de courant,
que des zones de passivation électriquement isolantes (10) sont formées de manière à être contiguës à ces parties latérales (8) et à se terminer au niveau de la surface,
que la face principale du substrat (0), tournée à l'opposé de la face principale couverte par croissance, est pourvue d'un contact de substrat (12),
que la couche de contact principal (7) est pourvue d'un contact médian (13), et
qu'au moins une partie latérale (8) est pourvue d'un contact latéral (14).

7. Laser DFB accordable suivant la revendication 6, caractérisé par le fait que pour chaque contact latéral (14), une couche latérale de contact (9) est formée par croissance sur la surface de la partie latérale concernée (8),
que cette couche de contact latéral (9) est fortement dopée pour le même type de conduction que la partie latérale (8), et
que le contact latéral (14) est disposé respectivement sur cette couche de contact latéral (9).

**8.** Laser DFB accordable suivant la revendication 6 ou 7, caractérisé en ce que

il est prévu une zone de diffusion (15), qui jouxte la partie, pourrve du contact médian (13), de la surface de la couche semiconductrice,

que cette zone de diffusion (15) possède un type de conduction opposé au type de conduction des parties latérales (8), et

que cette zone de diffusion (15) isole électriquement le contact médian (13) des parties latérales (8).

**9.** Laser DFB accordable suivant l'une des revendications 6 à 8, caractérisé par le fait

que le substrat (0), la couche centrale (4), la couche de revêtement (6) et les parties latérales (8) sont formées d'un matériau binaire, et

que d'autres couches sont formées d'un matériau quaternaire.

**10.** Laser DFB accordable suivant la revendication 9, caractérisé par le fait que le matériau binaire est du InP et que le matériau quaternaire est du InGaAsP.

**11.** Laser DFB accordable suivant la revendication 9, caractérisé par le fait que le matériau binaire est du InP et que le matériau quaternaire est du AlGaInAs.

**12.** Laser DFB accordable suivant l'une des revendications 1 à 8, caractérisé par le fait

que le substrat (0) est formé de GaAs, et

que les autres couches sont constituées par du $Al_xGa_{1-x}As$ ($0 \leqq x \leqq 1$).

**13.** Laser DFB accordable suivant l'une des revendications 1 à 8, caractérisé par le fait

que le substrat (0) est du GaSb, et

que les autres couches sont formées par le système Gasb/GaInAlAsSb.